# EUROPÄISCHE PATENTSCHRIFT

(11) **EP 0 977 979 B1**
(45) Veröffentlichungstag und Bekanntmachung des Hinweises auf die Patenterteilung: **07.12.2005**
(21) Anmeldenummer: 98931980.1
(22) Anmeldetag: 22.04.1998
(51) Int. Cl.: G01L 9/00, G01L 19/14, G01P 1/02

(54) **VERFAHREN ZUM HERSTELLEN EINER SENSORBAUGRUPPE SOWIE SENSORBAUGRUPPE**
METHOD FOR PRODUCING A SENSOR MODULE, AND CORRESPONDING SENSOR MODULE
PROCEDE POUR FABRIQUER UN MODULE DETECTEUR ET MODULE DETECTEUR AINSI OBTENU

(30) Priorität: 24.04.1997 DE 19717348
(43) Veröffentlichungstag der Anmeldung: 09.02.2000
(73) Patentinhaber: SIEMENS AKTIENGESELLSCHAFT, 80333 München (DE)
(72) Erfinder: BAUER, Hans-Peter, D-93047 Regensburg (DE)
(86) Internationale Anmeldenummer: PCT/DE1998/001130
(87) Internationale Veröffentlichungsnummer: WO 1998/048257

(56) Entgegenhaltungen:
- DE-A- 4 436 523
- US-A- 4 295 117
- US-A- 4 866 989
- PATENT ABSTRACTS OF JAPAN vol. 006, no. 229 (P-155), 16.November 1982 & JP 57 131031 A (HITACHI SEISAKUSHO KK), 13.August 1982,

## Beschreibung

Die Erfindung betrifft ein Verfahren zum Herstellen einer Sensorbaugruppe, gemäß dem Oberbegriff des Anspruchs 1. Die Erfindung betrifft weiter eine Sensorbaugruppe gemäß dem Oberbegriff des Anspruchs 9. Solche Sensorbaugruppen werden insbesondere in Insassenschutzsystemen von Kraftfahrzeugen verwendet.

Mit zunehmenden Einsatz elektronischer Steuerungen und Regelungen kommt der Sensorik steigende Bedeutung zu. Sensoren haltende Sensorbaugruppen sollen kostengünstig herstellbar sein und präzise, zuverlässige Ausgangssignale für die Steuerung nachgeschalteter Schaltungen liefern. Eine einfache Montage des Sensors bzw. der mit dem Sensor versehenen Sensorbaugruppe ist eine weitere wichtige Anforderung. Bei Verwendung solcher Sensorbaugruppen in Insassenschutzsystemen von Kraftfahrzeugen wird meist die Beschleunigung einer im Sensorelement enthaltenen trägen Masse gemessen, oder, insbesondere bei Seitenaufprallschutzeinrichtungen, wird eine Druckwelle erfaßt, die beispielsweise von einer plötzlichen Verformung eines Türaußenblechs ausgeht.

Die EP 0 297 961 A2 zeigt eine gattungsgemäße Sensorbaugruppe, deren Sensorelement auf Druck anspricht. Die Sensorbaugruppe weist ein Basisteil aus Kunststoff auf, das um ein Stanzgitter gespritzt ist. Innerhalb eines durch ein Loch im Basisteil gebildeten Sensoraufnahmebereiches enden Sensoranschlüsse des Stanzgitters. Zu einem Ende hin ist das Basisteil als Stecker ausgebildet, aus dem Enden des Stanzgitters als Steckeranschlüsse vorstehen. Ein Sensorelement wird auf einem aus Kunststoff bestehenden Tragteil befestigt, welches in den lochartigen Sensoraufnahmebereich einsetzbar ist und, beispielsweise durch Bonden, mit den Sensoranschlüssen elektrisch verbunden wird. Anschließend wird mit dem Basisteil ein den Sensor übergreifendes, weiteres Bauteil verklipst. Die Sensorbaugruppe ist insgesamt in ihrem Aufbau verhältnismäßig aufwendig. Vor Auswertung der über die Steckeranschlüsse abgegriffenen Ausgangssignale des Sensorelements wird ein weiteres Gerät zur Verarbeitung der Signale in EDV-gerechter Form benötigt, da eine Signalverarbeitung unmittelbar an der Sensorbaugruppe nicht vorgesehen ist.

Aus der EP 0 566 758 A1 ist eine Sensorbaugruppe bekannt, deren Sensorelement beschleunigungsempfindlich ist. Das Sensorelement ist über Anschlußfüßchen mit einer Leiterplatte verlötet und zusätzlich an Haltearmen gehalten, die mit der Leiterplatte verbunden sind. Die Leiterplatte ist innerhalb eines Gehäuses angeordnet, wobei zwischen der Leiterplatte und dem Gehäuse einerseits und dem Sensorelement und dem Gehäuse andererseits Dämpfungsmaterial angeordnet ist, das das Sensorelement vor extrem harten Stößen schützt. Auch der Aufbau dieser bekannten Sensoreinheit ist verhältnismäßig aufwendig.

Die US 4 295 117 A offenbart eine Sensorbaugruppe mit einem Basisteil aus Kunststoff, einem Sensorelement, einer Leiterplatte, einem Anschlußbereich mit elektrischen Steckeranschlüssen und elektrischen Verbindungen zwischen Sensor und Leiterplatte und zwischen Leiterplatte und Anschlußbereich. Eine vom Basisteil separat ausgebildete Einheit enthält die Sensoranschlüsse.

Die JP 57 131 031 A zeigt eine Sensorbaugruppe mit einem Basisteil aus Kunststoff, einem Sensorelement, einer Leiterplatte, einem Anschlußbereich mit elektrischen Steckeranschlüssen und elektrischen Verbindungen zwischen Leiterplatte und Anschlußbereich, wobei letztere in eine vom Basisteil separat ausgebildete Einheit eingegossen sind. Die Sensoranschlüsse werden ungehaltert vom Sensor zu einer Steuerschaltung geführt.

Die DE 4 436 523 A1 offenbart eine Sensorbaugruppe mit einem Sensorelement, einer Leiterplatte und einem Anschlußbereich mit elektrischen Steckeranschlüssen, wobei die Leiterplatte mit Kunststoff umspritzt ist unter Freibleiben der Steckeranschlüsse. Die Sensoranschlüsse werden ungehaltert vom Sensor zur Leiterplatte geführt.

Der Erfindung liegt die Aufgabe zugrunde, ein Verfahren zum Herstellen einer Sensorbaugruppe, insbesondere einer in Insassenschutzsystemen von Kraftfahrzeugen verwendbaren Sensorbaugruppe, zu schaffen, das bei einfacher Durchführbarkeit die kostengünstige Herstellung von an unterschiedlichen Anforderungen anpaßbaren, zuverlässig arbeitenden Sensorbaugruppen gestattet.

Der Erfindung liegt weiter die Aufgabe zugrunde, eine Sensorbaugruppe zu schaffen, die kostengünstig in großen Stückzahlen herstellbar ist, an die unterschiedliche Anforderungen anpaßbar ist und eine hohe Zuverlässigkeit aufweist.

Der das Verfahren betreffende Teil der Erfindungsaufgabe wird mit den Merkmalen des Anspruchs 1 gelöst.

Ein wesentliches Merkmal des erfindungsgemäßen Verfahrens liegt darin, daß eine Leiterplatte an dem fertigen Basisteil befestigt wird, wobei diese Leiterplatte entsprechend den jeweiligen Anforderungen bestückbar ist, so daß trotz unterschiedlicher Sensorelemente und unterschiedlich bestückter bzw. ausgebildeter Leiterplatten das gleiche Basisteil in großen Stückzahlen verwendet werden kann. Die Toleranzen der Sensorbaugruppe sind durch das vorgefertigte Basisteil mit dem Sensoraufnahmebereich und dem Anschlußbereich auf ein Minimum herabgesetzt.

Die abhängigen Ansprüche 2 bis 8 sind auf vorteilhafte Durchführungsformen des erfindungsgemäßen Verfahrens gerichtet.

Gemäß den Merkmalen des Anspruchs 2 wird die fertig bestückte Leiterplatte an dem Basisteil befestigt, so daß die Sensorbaugruppe als Satellit in einer komplexen Schaltung einsetzbar ist.

Gemäß dem Anspruch 3 werden die Steckeranschlüsse vorteilhafterweise bereits bei dessen Herstellung in das Basisteil eingegossen. Es versteht sich, daß auch ein Einpressen oder jedwede andere geeignete Befestigung möglich ist.

Die Merkmale der Ansprüche 4 und 5 sind auf eine einfache Anbringung des Sensorelements und dessen elektrischen Anschluß gerichtet.

Mit den Merkmalen des Anspruchs 6 wird der Vorteil erreicht, daß Beschleunigungen, die auf das Basisteil einwirken, unmittelbar auf das Sensorelement übertragen werden, da dieses durch die Verklebung praktisch einteilig mit dem Basisteil ausgebildet ist.

Gemäß dem Anspruch 7 ist es vorteilhaft, wenn am Basisteil Ausnehmungen vorgesehen sind, die die Leiterplatte geometrisch festlegen.

Mit den Merkmalen des Anspruchs 8 wird eine kompakte und ggf. hermetisch dichte Sensorbaugruppe geschaffen, bei der nur die Steckeranschlüsse sowie ggf. ein Kanal zum Sensorelement nach außen hin frei sind, wobei der Kanal beispielsweise vorgesehen sein kann, wenn das Sensorelement ein druckempfindliches Sensorelement ist. Es versteht sich, daß unmittelbar über dem Sensorelement zusätzlich eine Membran vorgesehen sein kann. Dadurch, daß die geometrische Zuordnung zwischen den Steckeranschlüssen und dem Sensorelement unmittelbar durch das Basisteil definiert ist, kann das Umspritzwerkzeug, in dem der Kanal zum Sensorelement und der Zugang zu den Steckeranschlüssen frei bleiben müssen, sehr toleranzgenau hergestellt werden. Somit wird eine einwandfreie Qualität der vollständig montagefertigen und abgedichteten Sensorbaugruppe erhalten.

Der auf die Sensorbaugruppe gerichtete Teil der Erfindungsaufgabe wird mit den Merkmalen des Anspruchs 9 gelöst, die den grundsätzlichen Aufbau der Sensorbaugruppe kennzeichnen.

Die Unteransprüche 10 bis 12 sind auf vorteilhafte Weiterbildungen der erfindungsgemäßen Sensorbaugruppe gerichtet.

Dadurch, daß die Leiterplatte die gesamte Ansteuer- und/oder Auswerteschaltung für das Sensorelement enthalten kann, wird eine kostengünstige und gleichzeitig funktionssichere Sensorbaugruppe geschaffen, die die Anforderungen an die weitere Schaltungsumgebung vermindert.

Mit der Erfindung werden neben der einfachen und toleranzgenauen Herstellbarkeit der Sensorbaugruppe zahlreiche weitere Vorteile erzielt. Beispielsweise wird, wenn das Sensorelement beschleunigungsempfindlich ist, eine präzise Bewegungsübertragung von einem Bauteil, an dem das Basisteil befestigt ist, auf das Sensorelement selbst erzielt. In der Bewegungsübertragung sind nur die Grenzflächen zwischen dem Bauteil, dessen Beschleunigung gemessen werden soll, und dem Basisteil (sowie ggf. dessen Umhüllung) und zwischen dem Basisteil und dem Sensorelement enthalten. Dies führt zu einer sehr guten und wohl definierten Meßempfindlichkeit.

Die Erfindung wird im folgenden anhand schematischer Zeichnungen beispielsweise und mit weiteren Einzelheiten erläutert.

Es stellen dar:
- Figur 1:: Eine perspektivische Darstellung der Bauteile der Sensorbaugruppe,
- Figur 2 bis 4:: Verschiedene Stufen der Herstellung der Sensorbaugruppe und
- Figur 5:: Die fertige, umspritzte Sensorbaugruppe.

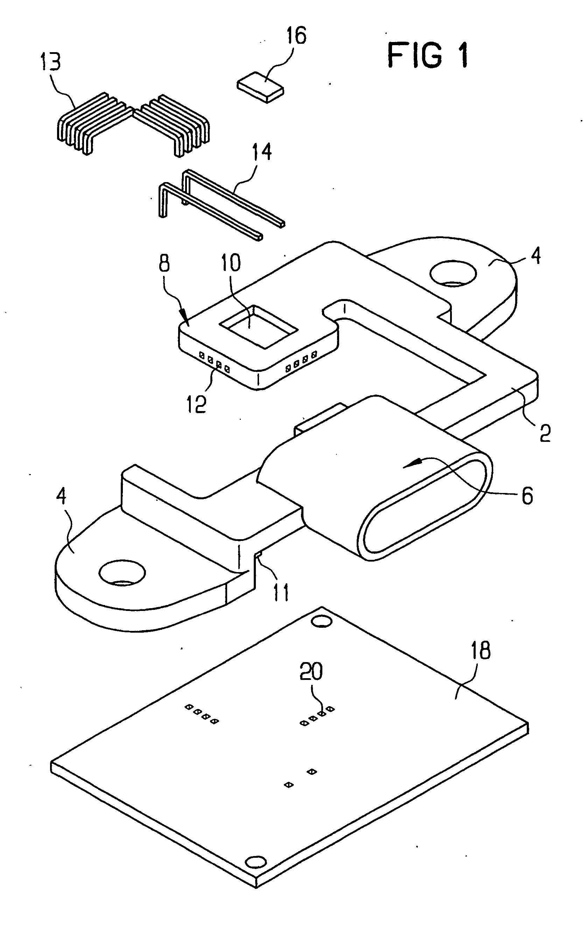

Gemäß Fig. 1 ist zur Herstellung der Sensorbaugruppe ein aus Kunststoff bestehendes Basisteil 2 vorgesehen, das einen Rahmen der gesamten Sensorbaugruppe bildet und beispielsweise spritzgegossen ist. An dem Basisteil 2 sind Befestigungsaugen 4 vorgesehen, sowie ein Anschlußbereich 6, der eine Hülse zum Einschieben eines Steckers bildet, und ein Sensoraufnahmebereich 8, der mit einer Ausnehmung 10 ausgebildet ist, und weiter Ausnehmungen 11 zur Aufnahme einer später beschriebenen Leiterplatte.

Am Sensoraufnahmebereich 8 sind Löcher 12 vorgesehen. Eine nicht dargestellte Rückwand des Anschlußbereiches 6 weist ebenfalls Löcher auf.

Weiter gehören zur Baugruppe Anschlußstifte 13 und 14, die zur leichteren Handhabbarkeit zunächst als Stanzgitterstruktur angeliefert werden. Ebenfalls sichtbar ist ein Sensorelement 16, das als Chip mit nach außen freiliegenden, nicht sichtbaren elektrischen Kontakten ausgebildet sein kann. Das Sensorelement 16 kann beispielsweise auf Druckänderungen oder auf Beschleunigungen ansprechen. Als Beschleunigungssensor enthält es beispielsweise eine seismische, träge Masse, deren Auslenkungen erfaßt werden. Als Drucksensor enthält es beispielsweise ein druckempfindliches Element, wie ein Piezoelement, eine Membran, usw..

Weiter ist eine Leiterplatte 18 vorgesehen, die auf ihrer nicht sichtbarer Rückseite mit elektronischen Bauteilen bestückt ist, die eine Ansteuer- und/oder Auswerteschaltung für das Sensorelement 16 bilden. Die Leiterplatte 18 ist mit Löchern 20 versehen, in die die Anschlußstifte 13, 14 einbringbar und dort beispielsweise durch Verlöten elektrisch anschließbar sind.

Der Zusammenbau der in Fig. 1 dargestellten Bauteile geschieht wie folgt:

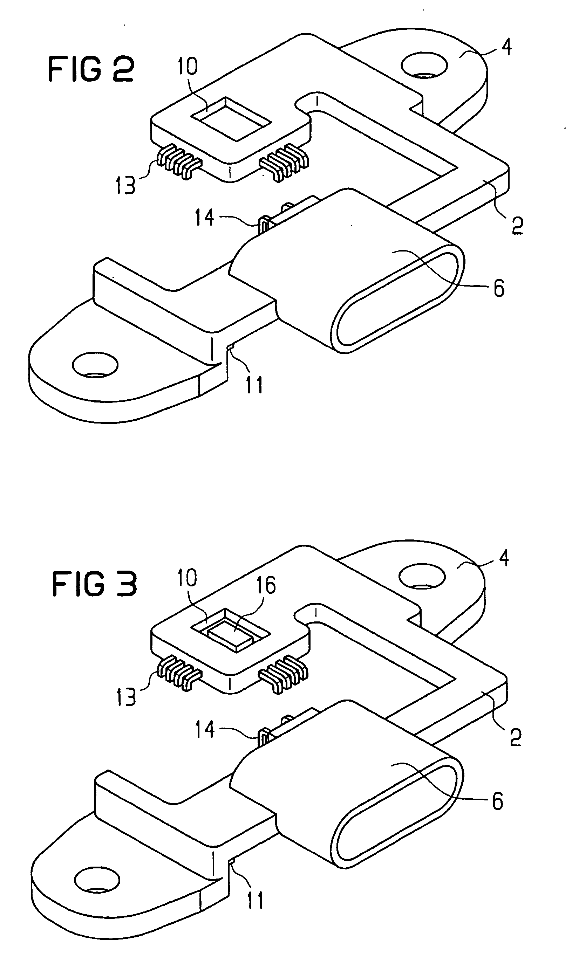

Gemäß Fig. 2 werden in einer ersten Verfahrensstufe die Anschlußstifte 13 und 14 in die dafür vorgesehenen Löcher des Basisteils 2 eingepreßt. Alternativ können die Anschlußstifte 13 auch unmittelbar beim Spritzgießen des Basisteils 2 in die Form eingebracht werden, so daß sie unmittelbar beim Spritzgießen des Basisteils 2 in dieses integriert werden. Die in die Ausnehmung 10 vorstehenden Bereiche der Anschlußstifte 13 bilden Sensoranschlüsse der elektrischen Kontaktierung des Sensorelements. Die in den Anschlußbereich 6 hinein vorstehenden Bereiche der Anschlußstifte 14 können unmittelbar die Steckeranschlüsse bilden.

In einer hachfolgenden Verfahrensstufe (Fig. 3) wird das Sensorelement 16 in die Ausnehmung 10 eingebracht und mit dem Boden der Ausnehmung beispielsweise verklebt. Es versteht sich, daß die Anordnung des Sensorelements 16 in der Ausnehmung 10 geometrisch wohl definiert erfolgt, indem der Boden der Ausnehmung 10 mit einer entsprechenden Aussparung versehen ist oder innerhalb der Ausnehmung 10 nicht dargestellte Stege ausgebildet sind, die das Sensorelement 16 positionieren. Anschließend werden die nicht dargestellten elektrischen Kontakte des Sensorelements 16 unmittelbar mit den Anschlußstiften 13 verlötet oder durch Drähtchen gebonded.

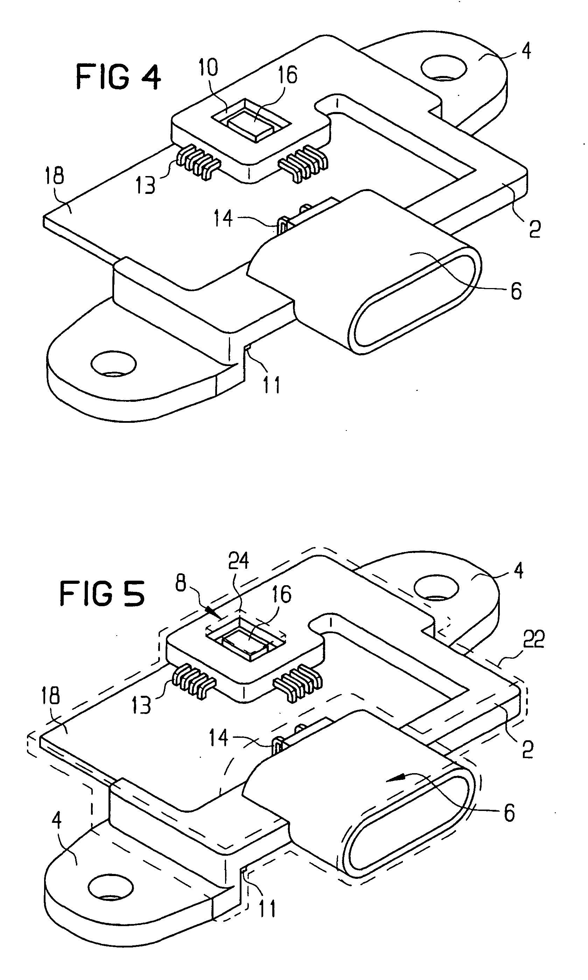

In einer nächsten Verfahrensstufe (Fig. 4) wird die Leiterplatte 18 von unten her in das Basisteil 2 eingebracht, wobei durch zweckentsprechende Ausbildung der nicht sichtbaren Unterseite des Basisteils 2 mit entsprechenden Ausnehmungen 11 Führungs- und Anlageflächen gebildet sind, die gewährleisten, daß die freien Enden der Anschlußstifte 13 in die Löcher 20 der Leiterplatte 18 einragen und von der Rückseite her mit den Leiterbahnen der Leiterplatte 18 verlötet oder in diese eingepreßt werden können. Es versteht sich, daß das Basisteil 2 und die Leiterplatte 18 mit Rastvorrichtungen zur gegenseitigen Verrastung versehen sein können.

Das Sensorelement 16 ist nun über die Anschlußstifte 13 mit der Leiterplatte 18 verbunden. Die Leiterplatte 18 ist über die Anschlußstifte 14 mit in das Innere des Anschlußbereiches 6 vorstehenden, in Fig. 5 nicht sichtbaren Steckeranschlüssen (beispielsweise durch die freien Enden der Anschlußstifte 14 gebildet) verbunden. Die gesamte Baugruppe wird in einer abschließenden Verfahrensstufe (Fig. 5) in einem Spritz- oder Gießvorgang mit einer Umhüllung 22 (gestrichelt eingetragen) versehen, wobei der Zugang zum Anschlußbereich 6 und vorteilhafterweise auch die Befestigungsaugen 4 frei bleiben. Wenn das Sensorelement 16 druckempfindlich ist, bleibt ein Kanal 24 zu einem druckempfindlichen Bereich des Sensorelements 16 bzw. das gesamte Sensorelement 16 frei, um dieses mit dem zu messenden Druck zu beaufschlagen.

Die gesamte Baugruppe ist im übrigen durch die Ummantelung 22 hermetisch nach außen abgeschlossen und in sich außerordentlich stabil.

Bei dem Umspritzen bzw. Ummanteln ist eine eindeutige Zuordnung zwischen dem ggf. vorhandenen Kanal 24 und dem frei bleibenden Bereich des Anschlußbereiches 6 vorhanden, da die Geometrie ausschließlich durch das Basisteil 2 bestimmt ist. Dies gewährleistet einwandfreie Qualität der hergestellten Sensorbaugruppe. Weiter ist die Baugruppe mit aller notwendigen Elektronik versehen, so daß ein in den Anschlußbereich 6 einschiebbarer Stecker lediglich der Stromversorgung und dem Anschluß von bereits verarbeiteten Ausgangssignalen an beispielsweise ein elektronisches Steuergerät dient.

Mittels der Befestigungsaugen 4 kann die gesamte Sensorbaugruppe unmittelbar auf ein Bauteil aufgeschraubt werden, dessen Beschleunigung oder dessen Schwingungsverhalten beispielsweise gemessen werden soll. Die Messung ist sehr präzise, da die Schwingungen lediglich die Grenzfläche zwischen dem zu messenden Bauteil (nicht dargestellt) und dem Basisteil 2 und die Grenzfläche zwischen dem Basisteil 2 und dem Sensorelement 16 passieren müssen.

Es versteht sich, daß zahlreiche Abänderungen möglich sind. Beispielsweise kann das Sensorelement 16 lediglich durch Verlöten mit den Anschlußstiften 13 befestigt sein. Weiter kann die Leiterplatte 18 zusätzlich mit dem Basisteil 2 verklebt sein. Die Ausnehmung kann im Bereich des Sensorelements 16 von der Ummantelung 22 frei sein und mittels eines Deckels verschlossen werden, so daß das Sensorelement beispielsweise zum Auswechseln zugänglich ist. Die Leiterplatte kann als Stanzgitter (lead-frame) ausgebildet sein.

## Patentansprüche

1. Verfahren zum Herstellen einer Sensorbaugruppe
mit einem aus Kunststoff bestehenden Basisteil (2) mit einem Sensoraufnahmebereich (8) und mit einem Anschlußbereich (6),
mit Sensoranschlüssen (13) im Sensoraufnahmebereich (8), die von dem Basisteil (2) gehalten werden,
mit Steckeranschlüssen (14) im Anschlußbereich (6), die von dem Basisteil (2) gehalten werden, und
mit einem Sensorelement mit elektrischen Kontakten, die mit den Sensoranschlüssen elektrisch leitend verbunden sind,
enthaltend folgende Verfahrensschritte
Herstellen des Basisteils (2) mit dem Anschlußbereich (6) aus Kunststoff,
Befestigen einer Leiterplatte (18) an dem Basisteil (2),
Anbringen des Sensorelements (16) an dem Basisteil (2) mit Herstellen der elektrischen Verbindung zwischen dem Sensorelement und der Leiterplatte, und
Herstellen der elektrischen Verbindung zwischen der Leiterplatte und den Steckeranschlüssen (14).

2. Verfahren nach Anspruch 1, wobei die Leiterplatte (18) vor ihrem Anbringen am Basisteil (2) mit einer Ansteuerschaltung und/oder Auswerteschaltung für das Sensorelement (16) bestückt wird.

3. Verfahren nach Anspruch 1 oder 2, wobei die Steckeranschlüsse (14) in das Basisteil (2) bei dessen Herstellung eingegossen werden.

4. Verfahren nach einem der Ansprüche 1 bis 3, enthaltend die Verfahrensschritte
Anbringen von Sensoranschlüssen (13) an dem Basisteil (2),
Herstellen der elektrischen Verbindung zwischen dem Sensorelement (16) und den Sensoranschlüssen (13) sowie zwischen den Sensoranschlüssen (12) und der Leiterplatte (18).

5. Verfahren nach Anspruch 4, wobei die Sensoranschlüsse (13) in das Basisteil (2) bei dessen Herstellung eingegossen werden.

6. Verfahren nach einem der Ansprüche 1 bis 5, wobei das Sensorelement (16) durch Verkleben an dem Basisteil (2) befestigt wird.

7. Verfahren nach einem der Ansprüche 1 bis 6, wobei die Leiterplatte (18) in am Basisteil (2) vorgesehene Ausnehmungen (1) eingesetzt wird.

8. Verfahren nach einem der Ansprüche 1 bis 7, wobei die Anordnung aus Basisteil (2), Leiterplatte (18) und Sensorelement (16) unter Freibleiben der Steckeranschlüsse innerhalb des Anschlußbereiches (16) sowie ggf. eines Kanals (24) zum Sensorelement mit Kunststoff umspritzt wird.

9. Sensorbaugruppe enthaltend
ein aus Kunststoff bestehendes Basisteil (2) mit einem Sensoraufnahmebereich (8) und mit einem Anschlußbereich (6),
Sensoranschlüsse (13) im Sensoraufnahmebereich (8) die von dem Basisteil (2) gehalten werden,
Steckeranschlüsse (14) im Anschlußbereich (6) die von dem Basisteil (2) gehalten werden,
ein Sensorelement (16) mit elektrischen Kontakten, die mit den Sensoranschlüssen elektrisch leitend verbunden sind, und
eine an dem Basisteil (2) befestigte Leiterplatte (18) über die die elektrische Verbindung zwischen dem Sensorelement (16) und den Steckeranschlüssen (14) erfolgt.

10. Sensorbaugruppe nach Anspruch 9, **dadurch gekennzeichnet, daß** das Sensorelement (16) einen Beschleunigungssensor enthält, und unmittelbar an dem Basisteil (2) befestigt ist.

11. Sensorbaugruppe nach einem der Ansprüche 8 oder 9, **dadurch gekennzeichnet, daß** die Leiterplatte (18) eine Ansteuerschaltung und/oder Auswerteschaltung für das Sensorelement enthält.

12. Sensorbaugruppe nach einem der Ansprüche 9 bis 11, **dadurch gekennzeichnet, daß** die Anordnung aus Basisteil (2), Leiterplatte (18) und Sensorelement (16) unter Freibleiben der Steckeranschlüsse innerhalb des Anschlußbereiches (6) sowie ggf. eines Kanals (24) zum Sensorelement mit Kunststoff umspritzt ist.

## Claims

1. Method for manufacturing a sensor subassembly
having a base part (2) made of plastic with a sensor holding area (8) and with a connection area (6),
having sensor connections (13) in the sensor holding area (8) which are retained by the base part (2),
having plug connections (14) in the connection area (6) which are retained by the base part (2),
having a sensor element with electrical contacts which are electrically conductively connected to the sensor connections,
comprising the following method steps:
manufacture the base part (2) with the connection area (6) from plastic,
fix a printed circuit board (18) to the base part (2),
attach the sensor element (16) to the base part (2) with establishment of the electrical connection between the sensor element and the printed circuit board, and
establish the electrical connection between the printed circuit board and the plug connections (14).

2. Method according to claim 1, wherein the printed circuit board (18) is equipped with a drive circuit and/or an evaluation circuit for the sensor element (16) before the printed circuit board (18) is fitted to the base part (2).

3. Method according to claim 1 or 2, wherein the plug connections (14) are cast into the base part (2) during the manufacture of the base part (2).

4. Method according to one of the claims 1 to 3, comprising the method steps:
attach sensor connections (13) to the base part (2),
establish the electrical connection between the sensor element (16) and the sensor connections (13) and between the sensor connections (13) and the printed circuit board (18).

5. Method according to claim 4, wherein the sensor connections (13) are cast into the base part (2) during the manufacture of the base part (2).

6. Method according to one of the claims 1 to 5, wherein the sensor element (16) is fixed to the base part (23) by means of an adhesive bonding.

7. Method according to one of the claims 1 to 6, wherein the printed circuit board (18) is inserted into recesses (1) provided on the base part (2).

8. Method according to one of the claims 1 to 7, wherein the arrangement consisting of base part (2), printed circuit board (18) and sensor element (16) is encapsulated with plastic applied by injection moulding, said encapsulation leaving exposed the plug connections within the connection area (16) and where appropriate also a channel (24) to the sensor element.

9. Sensor subassembly, comprising
a plastic base part (2) having a sensor holding area (8) and a connection area (6),
sensor connections (13) in the sensor holding area (8) which are retained by the base part (2),
plug connections (14) in the connection area (6) which are retained by the base part (2),
a sensor element (16) having electrical contacts which are electrically conductively connected to the sensor connections, and
a printed circuit board (18) fixed to the base part (2) and via which the electrical connection between the sensor element (16) and the plug connections (14) is established.

10. Sensor subassembly according to claim 9, **characterised in that** the sensor element (16) contains an acceleration sensor and is fixed directly to the base part (2).

11. Sensor subassembly according to one of the claims 8 or 9, **characterised in that** the printed circuit board (18) contains a drive circuit and/or an evaluation circuit for the sensor element.

12. Sensor subassembly according to one of the claims 9 to 11, **characterised in that** the arrangement consisting of base part (2), printed circuit board (18) and sensor element (16) is encapsulated with plastic applied by injection moulding, said encapsulation leaving exposed the plug connections within the connection area (6) and where appropriate also a channel (24) to the sensor element.

## Revendications

1. Procédé de fabrication d'un bloc capteur comprenant
une partie de base(2) en matière plastique possédant une région (8) de logement du capteur et une région de connexion (6),
des connexions de capteur (13) placées dans la région (8) de logement du capteur et qui sont tenues par la partie de base (2),
des connexions à broche (14) dans la région de connexion (6), qui sont tenues par la partie de base (2), et
un élément capteur possédant des contacts électriques qui sont reliés aux connexions de capteur par une liaison conductrice d'électricité,
comportant les étapes de procédé suivantes
fabrication de la partie de base (2) avec la région de connexion (6) en matière plastique,
fixation d'un circuit imprimé (18) à la partie de base (2),
mise en place de l'élément capteur (16) sur la partie de base (2), avec établissement de la liaison électrique entre l'élément capteur et le circuit imprimé, et
fabrication de la liaison électrique entre le circuit imprimé et les connexions à broche (14).

2. Procédé selon la revendication 1, dans lequel le circuit imprimé (18) est
équipé d'un circuit de commande et/ou d'un circuit d'exploitation pour l'élément capteur (16) avant sa mise en place sur la partie de base (2).

3. Procédé selon la revendication 1 ou 2, dans lequel les connexions à broche (14) sont moulées dans la partie de base (2) lors de sa fabrication.

4. Procédé selon une des revendications 1 à 3, comprenant les étapes suivantes :
mise en place de connexions de capteur (13) en place sur la partie de base (2),
fabrication de la liaison électrique entre l'élément capteur (16) et les connexions de capteur (13) ainsi qu'entre les connexions de capteur (12) et le circuit imprimé (18)

5. Procédé selon la revendication 4, dans lequel les connexions de capteur (13) sont moulées dans la partie de base (2) lors de sa fabrication.

6. Procédé selon une des revendications 1 à 5, dans lequel l'élément capteur (16) est fixé à la partie de base (2) par collage.

7. Procédé selon une des revendications 1 à 6, dans lequel le circuit imprimé (18) est inséré dans des évidements (1) prévus sur la partie de base (2).

8. Procédé selon une des revendications 1 à 7, dans lequel le dispositif composé de la partie de base (2), du circuit imprimé (18) et de l'élément capteur (16) est surmoulé avec de la matière plastique en laissant libres les connexions à broche à l'intérieur de la région de connexion (16) ainsi qu'éventuellement d'un canal (24) aboutissant à l'élément capteur.

9. Bloc capteur, comprenant
une partie de base (2) réalisée en matière plastique, possédant une région (8) de logement de capteur et une région de connexion (6),
des connexions de capteur (13) situées dans la région (8) de logement de capteur, qui sont tenue par la partie de base (2)
des connexions à broche (14) dans la région de connexion (6) qui sont tenues par la partie de base (2)
un élément capteur (16) possédant des contacts électriques qui sont reliés aux connexions de capteur par une liaison conductrice de l'électricité et
un circuit imprimé (18) fixé à la partie de base (2) et par l'intermédiaire duquel s'effectue la liaison électrique entre l'élément capteur (16) et les connexions à broche (14) .

10. Bloc capteur selon la revendication 9, **caractérisé en ce que** l'élément capteur (16) comprend un capteur d'accélération et est fixé directement à la partie de base (2).

11. Bloc capteur selon une des revendications 8 ou 9, **caractérisé en ce que** le circuit imprimé (18) comprend un circuit de commande et/ou un circuit d'exploitation pour l'élément capteur.

12. Bloc capteur selon une des revendications 9 à 11, **caractérisé en ce que** l'ensemble de la partie de base (2), du circuit imprimé (18) et de l'élément capteur (16) est surmoulé avec de la matière plastique en laissant libres les connexions à broche à l'intérieur de la région de connexion (6), ainsi qu'éventuellement un canal (24) menant à l'élément capteur.
